(19) Europäisches Patentamt
European Patent Office
Office européen des brevets

(11) **EP 1 292 015 B1**

(12) **EUROPÄISCHE PATENTSCHRIFT**

(45) Veröffentlichungstag und Bekanntmachung des Hinweises auf die Patenterteilung:
**01.04.2009 Patentblatt 2009/14**

(51) Int Cl.:
***H03C 1/60*** *(2006.01)*

(21) Anmeldenummer: **02450171.0**

(22) Anmeldetag: **02.08.2002**

(54) **Stereo multiplex encoder (MPX) zur FM Übertragung**

Stereo Multiplex Encoder (MPX) for FM Transmission

Codeur-Multiplex-Stéréo (MPX) pour transmission à modulation de fréquence

(84) Benannte Vertragsstaaten:
**AT BE BG CH CY CZ DE DK EE ES FI FR GB GR IE IT LI LU MC NL PT SE SK TR**

(30) Priorität: **24.08.2001 AT 13522001**

(43) Veröffentlichungstag der Anmeldung:
**12.03.2003 Patentblatt 2003/11**

(73) Patentinhaber: **AKG Acoustics GmbH**
**1230 Wien (AT)**

(72) Erfinder:
• **Schlager, Peter, Dipl.-Ing.**
**3204 Kirchberg a/d Pielach (AT)**

• **Breitschädel, Hannes, Dipl.-Ing.**
**1150 Wien (AT)**

(74) Vertreter: **Patentanwälte**
**BARGER, PISO & PARTNER**
**Mahlerstrasse 9**
**P. O. Box 96**
**1015 Wien (AT)**

(56) Entgegenhaltungen:
DE-A- 4 210 069     US-A- 4 835 791
US-A- 4 955 072     US-A- 5 115 468

**Beschreibung**

Gegenstand der Erfindung ist die Implementation eines Stereo Multiplex Encoders (MPX) zur FM Übertragung mit einem digitalen Signalprozessor.

Derartige Verfahren sind bekannt, beispielsweise aus der US 4,835,791 A, der US 5,115,468 A und der DE 42 10 069 A. Bei all diesen Druckschriften wird zum Vermeiden des Aliasing entweder ein Hilbert Transformator oder ein PSN (Phase Shift Network), somit ebenfalls ein rechenintensives Verfahren, verwendet.

Die Erfindung hat das Ziel, ein deutlich weniger rechenintensives Verfahren anzugeben, ohne dass dadurch die Qualität herabgesetzt wird.

Erfindungsgemäß kommen folgende Neuerungen zur Anwendung:

1. Verwendung der Restseitenbandmodulation anstatt der üblichen Doppelseitenbandmodulation bei der Stereoübertragung.

2. Abstimmung der Samplingfrequenz auf die Modulationsfrequenz (fmod = fs/2). Die Verarbeitung der Daten erfolgt bei der Samplingfrequenz von 76 kHz. Dadurch kann das Antialiasingfilter des DAC verwendet werden, welches das restseitenbandmodulierte Signal erzeugt.

3. Die entstehenden Aliasingprodukte führen durch die Auswahl der Modulations und Abtastfrequenz bei dieser Anwendung automatisch zur notwendigen Pegelanhebung des unteren Seitenbandes.

4. Verbesserung der frequenzabhängigen Kanaltrennung zwische Links und Rechts durch Abgleich der Phase des Pilottons und Pegelanpassung des Mittensignals. Dadurch können die Ripple- und Phasennichtlinearitäten im Antialiasing Filter des DAC ausgeglichen werden.

Die Erfindung wird in der Folge unter Bezugnahme auf die Zeichnung näher erläutert. Dabei zeigt die

Fig. 1 die Funktion der Ausgangsfrequenz in Abhängigkeit von der Eingangsfrequenz bei der Amplitudenmodulation, die

Fig. 2 die Anhebung der Amplitude des unteren Seitenbandes bei Abtastung eines amplitudenmodulierten Signales mit der Abtastfrequenz fmod = fs/2, die

Fig. 3 das resultierende Spektrum bei der Abtastung eines amplitudenmodulierten Signals, die

Fig. 4 das Erzeugen des Modulators bei einer Abtastrate fs = 2∗fmod, die

Fig. 5 das Erzeugen des Pilottons mit der Frequenz 19 kHz bei einer Modulationsfrequenz fmod = 38 kHz und einer Abtastrate fs = 76 kHz, die

Fig. 6 das Erzeugen des Multiplexsignals aus dem linken und rechten Stereosignal und die

Fig. 7 ein reales Antialiasing Filter, man erkennt Ripple im Durchlaßbereich des Anti Aliasing Filters.

Theoretische Grundlagen:

Durch Auswahl der Abtastrate und Modulationsfrequenz (Amplitudenmodulation) werden bewußt Aliasing Effekte erzeugt, die zuletzt das gewünschte Modulationssignal ergeben.

Amplitudenmodulation:

Bei der Amplitudenmodulation eines Analogsignals mit der Frequenz fe und der Modulationsfrequenz fmod (Bild 1) entsteht ein Spektrum mit den Frequenzen

$$f1 = fmod-fe$$

$$f2 = fmod+fe$$

.

Abtastung:

Bei der Abtastung eines Analogsignales mit einem Analog Digital Converter (ADC) ohne Anti-Aliasing Filter ergibt sich folgender Zusammenhang zwischen Eingangs- und Ausgangssignalfrequenz:

Bis zur halben Abtastfrequenz (Eingangssignal) repräsentiert die Folge am Ausgang des ADC genau die Folge des Eingangssignals. Bei weiterer Erhöhung der Eingangsfrequenz sinkt die Frequenz der Ausgangsfolge wieder ab.

Aliasing tritt auf.

Verknüpfung von Modulation und Abtastung:

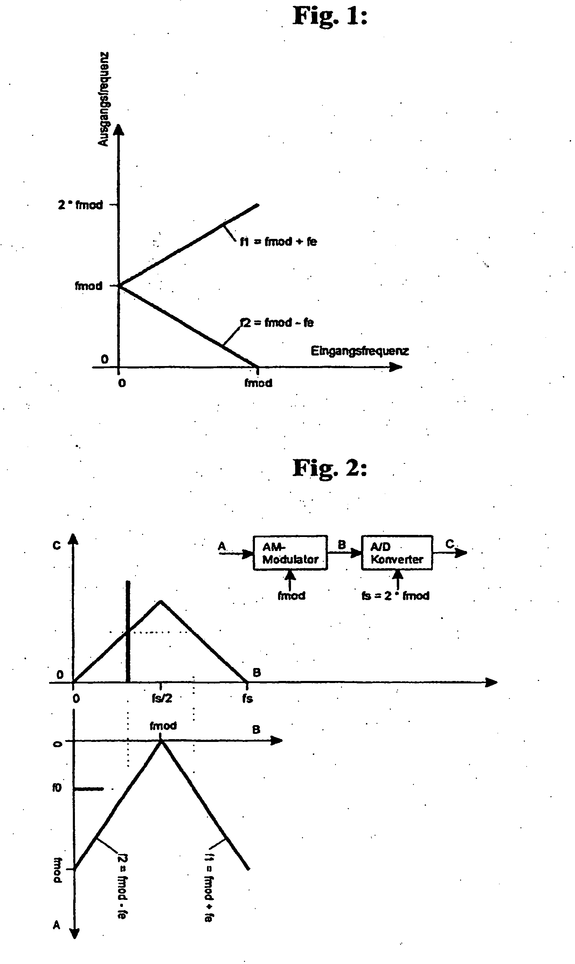

Das amplitudenmodulierte Signal wird abgetastet. Ist die Abtastfrequenz die doppelte Modulationsfrequenz entsteht für das obere Seitenband des amplitudenmodulierten Signals Aliasing, wobei das obere Seitenband in das untere hineingespiegelt wird. Der Phasenunterschied ist gleich null, daher ergibt sich für das entstehende untere Seitenband die doppelte Amplitude Fig 2).

Man erspart sich die bei SSB (Single Sideband) Modulation mit der Filtermethode notwendige Anhebung des Seitenbandes.

Digital / Analog Umsetzung:

Das Spektrum der Zahlenfolge, die beim oben beschriebenen Verfahren entsteht, ist periodisch. Das Spektrum des Basisbandes (0 bis 38kHz) wird periodisch mit den Vielfachen der Abtastfrequenz (76 KHz) gefaltet.

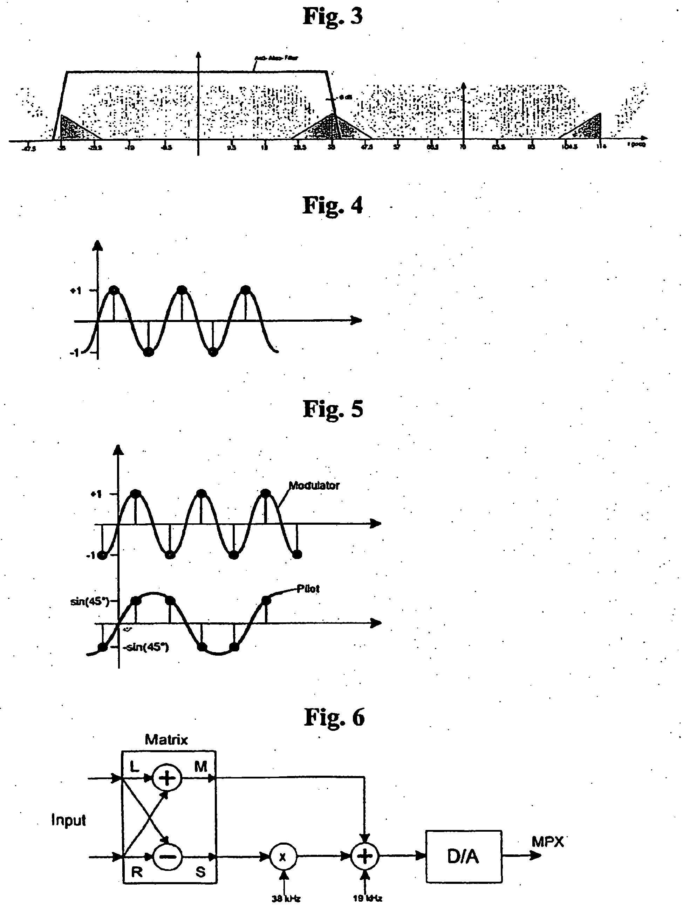

Jeder Digital Analog Converter (DAC) hat am Ausgang ein Tiefpaßfilter, das die unerwünschten Frequenzen ausblendet und nur das Basisband übrigläßt. Das Antialiasing Filter eines DAC ist so gebaut, dass es bei der halben Abtastfrequenz genau 6 dB Dämpfung hat. Interessant ist der Bereich um 38 kHz. Durch die Periodizität des Spektrums ist aus der Einseitenbandmodulation wieder eine Doppelseitenbandmodulation geworden. Am Analogausgang kann man daher eine Restseitenbandmodulation messen. (Fig. 3). Das Filter läßt die Hälfte des urspünglichen Anteils bezüglich der Trägerfrequenz passieren und hat eine Filtercharakteristik welche eine ungerade Symmetrie bei den Amplituden des oberen und unteren Seitenbandes ergibt. Bei dieser ungeraden Filterung addieren sich bei der Demodulation die Beträge der beiden Seitenbänder zum korrekten Basisbandsignal für alle Modulationsfrequenzen.

Modulator:

Der Modulator ist bei Standard MPX ein Sinussignal mit 38kHz. Verwendet man das oben beschriebene Verfahren, so muß die Abtastrate 76kHz betragen. Bei einem Sinus der Frequenz 38 kHz, abgetastet mit einer Frequenz von 76 kHz handelt es sich um eine Folge von ‚+1' und ‚-1'. (Fig. 4).

Pilotton:

Der Pilotton hat exakt die halbe Frequenz des Modulators, und ist mit 0° phasenstarr. Die Phasenlage des Pilottons ist abgleichbar. Aus diesem Zusammenhang ergeben sich die vier Samples des Pilottons (Fig. 5). Der Pegel des Pilottons beträgt 10% des max. Modulationspegels.

$$s_1 = A \cdot \sin(45° + \varphi)$$

$$s_2 = A \cdot \sin(135° + \varphi)$$

$$s_3 = A \cdot \sin(225° + \varphi)$$

$$s_4 = A \cdot \sin(315° + \varphi)$$

s1..s4    die vier verschiedenen Pilottonsamples
A         Amplitude
φ         Phasen Offset

Multiplexsignal:

An den Input kommen zwei digitale Zahlenfolgen (Links, Rechts) mit einer Samplerate von 76 kHz. Eine Matrix erzeugt daraus das Mitten und Seitensignal (Fig. 6):

$$M = L + R$$

$$S = L - R$$

Der Modulator ist, wie oben beschrieben' eine Zahlenfolge +1,-1,+1 .... Für das Seitensignal erhält man nach der Modulation demnach die Folge

$$+S = L - R$$

$$-S = -L + R$$

$$+S = L - R$$

etc...
Das Seitenband befindet sich nach der Modulation im Frequenzbereich von 22 bis 38 kHz. Die Folge des modulierten Seitenbandsignals wird zum Mittensignal addiert.

$$M + S = M + (L - R) = (L + R) + (L - R) = 2L$$

$$M - S = M - (L - R) = (L + R) - (L - R) = 2R$$

$$M + S = M + (L - R) = (L + R) + (L - R) = 2L$$

*etc...*

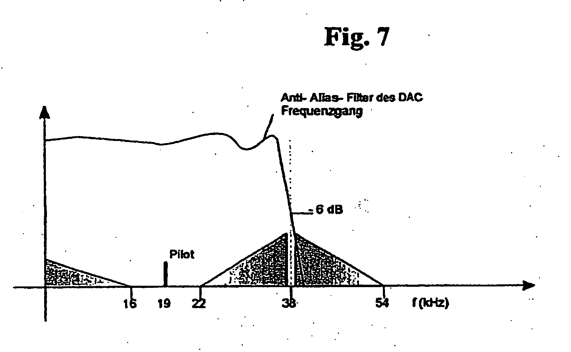

Daraus sieht man, daß man statt der Matrix mit anschließendem Modulator auch einen Schalter, der zwischen 2L und 2R hin- und hergeschaltet wird, verwenden kann.
Um den Filterripple (Fig. 7) des DAC auszugleichen muß das Mittensignal im Pegel leicht abgesenkt werden. Verzichtet man auf diesen Abgleich (Schaltermethode) erhält man einen einfacheren Algorithmus auf Kosten einer schlechteren Kanaltrennung.
Die Modulation im DSP wird durch abwechselnde Addition und Subtraktion des Seitensignals vom Mittensignals berechnet. Um das vollständiges Multiplexsignal zu erhalten muß der Pilotton addiert werden. Für diesen gibt es vier sich periodisch wiederholende Koeffizienten, die in einer Tabelle abgespeichert sind.
Die Zahlenfolge des Multiplexsignals ergibt sich zusammenfassend zu

$$MPX_1 = M_1 + S_1 + Pilot_1$$

$$MPX_2 = M_2 - S_2 + Pilot_2$$

$$MPX_3 = M_3 + S_3 + Pilot_3$$

$$MPX_4 = M_4 - S_4 + Pilot_4$$

$$MPX_5 = M_5 + S_5 + Pilot_1$$

MPX$_1$...       Zahlenfolge des Multiplex- Signals
M$_1$...       Zahlenfolge des Mitten- Signals
S$_1$...       Zahlenfolge des Seiten- Signals
Pilot$_1$...Pilot$_4$       Zahlenfolge der vier Pilotton- Koeffizienten (periodisch)

Modulatorabgleich auf einen DAC:

Alle bisherigen Überlegungen gehen von einem idealen Antialiasing Tiefpaß im DAC aus. Reale Tiefpässe weisen aber eine Welligkeit im Durchlaßbereich sowie eine nichtkonstante Gruppenlaufzeit auf.

Die Welligkeit wirkt sich folgendermaßen aus: Zur Rückgewinnung des L, R Signals aus dem M, S Signal muß die inverse Matrix gebildet werden.

$$2L = M + S = (L + R) + (L - R)$$

$$2R = M - S = (L + R) - (L - R)$$

Das Seitensignal befindet sich in einem anderen Frequenzbereich als das Mittensignal. Durch Abweichungen des Seitensignalpegels von 0 dB infolge von Welligkeiten des Antialiasingfilters, funktioniert die inverse Matrix nicht mehr exakt und man erhält ein Kanalübersprechen. Ähnliche Bedingungen gelten für die Konstanz der Gruppenlaufzeit (Linearität der Phase). Die Effekte des Antialiasing Tiefpaßfilters des DAC äußern sich also in einer frequenzabhängigen Kanaltrennung. Um diese Effekte zu kompensieren, ist die Phase des Pilottons und der Pegel des Mittensignals abgleichbar.

**Patentansprüche**

1. Stereo Multiplex Encoder zur FM Übertragung, mit einem digitalen Signalprozessor, **dadurch gekennzeichnet, dass** bei der Stereoübertragung Restseitenbandmodulation anstatt der üblichen Doppelseitenbandmodulation angewandt wird und dass die Abstimmung der Samplingfrequenz auf die doppelte Modulationsfrequenz erfolgt, wodurch das Antialiasingfilter des DAC verwendet werden kann, welches das restseitenbandmodulierte Signal erzeugt.

2. Verfahren nach Anspruch 1, **dadurch gekennzeichnet, dass** die frequenzabhängige Kanaltrennung zwischen Links und Rechts durch Abgleich der Phases des Pilottons und Pegelanpassung des Mittensignals erfolgt, wodurch Ripple- und Phasennichtlinearitäten im Antialiasing Filter des DAC ausgeglichen werden können.

**Claims**

1. A stereo multiplex encoder for FM transmission with a digital signal processor, **characterised in that** residual sideband modulation is used in stereo transmission instead of the usual double sideband modulation and that tuning of the sampling frequency to twice the modulation frequency is effected, whereby the anti-aliasing filter of the DAC can be used, which produces the residual sideband modulated signal.

2. A method is claimed in Claim 1, **characterised in that** the frequency-dependent channel separation between left and right is effected by balancing the phase of the pilot tone and level matching of the centre signal, whereby ripple and phase non-linearities can be compensated for in the anti-aliasing filter of the DAC.

**Revendications**

1. Codeur stéréo multiplex pour la transmission FM, comportant un processeur de signal numérique, **caractérisé par le fait que**, lors de la transmission stéréo, on applique une modulation à bande latérale résiduelle au lieu de la modulation à double bande latérale habituelle et qu'on effectue le réglage de la fréquence d'échantillonnage sur la double fréquence de modulation, permettant d'utiliser le filtre anti-repliement du CAD, qui produit le signal modulé à bande latérale résiduelle.

2. Procédé selon la revendication 1, **caractérisé par le fait que** la séparation de canal, en fonction de la fréquence, entre la droite et la gauche se fait par alignement de phase de la tonalité pilote et par adaptation de niveau du signal central, permettant d'égaliser des non-linéarités d'ondulation et de phase dans le filtre anti-repliement du CAD.

# Fig. 1:

# Fig. 2:

## Fig. 3

## Fig. 4

## Fig. 5

## Fig. 6

# Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4835791 A
- US 5115468 A
- DE 4210069 A